# EUROPÄISCHE PATENTSCHRIFT

(11) **EP 1 141 867 B1**
(45) Veröffentlichungstag und Bekanntmachung des Hinweises auf die Patenterteilung: **09.08.2006**
(21) Anmeldenummer: 00904820.8
(22) Anmeldetag: 03.01.2000
(51) Int. Cl.: G06F 17/50

(54) **VERFAHREN UND ANORDNUNG ZUR VERIFIKATION EINES LAYOUTS EINER INTEGRIERTEN SCHALTUNG MIT HILFE EINES RECHNERS SOWIE DESSEN ANWENDUNG ZUR HERSTELLUNG EINER INTEGRIERTEN SCHALTUNG**
METHOD AND ARRANGEMENT FOR VERIFYING THE LAYOUT OF AN INTEGRATED CIRCUIT WITH THE AID OF A COMPUTER AND USE THEREOF IN THE PRODUCTION OF AN INTEGRATED CIRCUIT
PROCEDE ET DISPOSITIF DE VERIFICATION DU TRACE D'UN CIRCUIT INTEGRE A L'AIDE D'UN ORDINATEUR AINSI QUE SON UTILISATION POUR FABRIQUER UN CIRCUIT INTEGRE

(30) Priorität: 13.01.1999 DE 19900980
(43) Veröffentlichungstag der Anmeldung: 10.10.2001
(73) Patentinhaber: Infineon Technologies AG, 81669 München (DE)
(72) Erfinder: REIN, Achim, D-81379 München (DE); FRERICHS, Martin, D-81379 München (DE)
(74) Vertreter: Epping - Hermann - Fischer
(86) Internationale Anmeldenummer: PCT/DE2000/000023
(87) Internationale Veröffentlichungsnummer: WO 2000/042534

(56) Entgegenhaltungen:
- US-A- 5 452 224
- US-A- 5 706 206
- US-A- 5 761 080
- US-A- 5 828 580

## Beschreibung

Verfahren und Anordnung zur Verifikation eines Layouts einer integrierten Schaltung mit Hilfe eines Rechners sowie dessen Anwendung zur Herstellung einer integrierten Schaltung.

Bei der Realisierung hochintegrierter Schaltungen wird üblicherweise zunächst ein Schaltungsentwurf erstellt, in dem spezifiziert ist, welche Bauelemente vorgesehen sind und welches Schaltverhalten die integrierte Schaltung aufweisen soll. Ausgehend von diesem Schaltungsentwurf wird ein Layout erstellt, das die geometrische Form und Anordnung aller Komponenten der Schaltungsanordnung beschreibt. Zu den Komponenten sind insbesondere dotierte Gebiete, isolierende Strukturen, leitende Strukturen, Metallisierungsebenen, Kontakte, etc. zu zählen. Das Layout wird in der Regel mit Hilfe eines Rechners erstellt und kann sowohl als Datei als auch als Plan vorliegen. Das Layout ist die Grundlage zur Erstellung von Maskensätzen, die nachfolgend bei der technologischen Herstellung der integrierten Schaltung verwendet werden.

Durch Ungenauigkeiten, Designfehler und Kompromisse, etwa bei Mindestabmessungen, bei der Erstellung des Layouts ist es möglich, daß die entsprechend einem Layout hergestellte Schaltung andere Eigenschaften hat, als im Schaltungsentwurf gefordert. Um sicherzugehen, daß die hergestellte Schaltung möglichst genau entsprechend dem Schaltungsentwurf funktioniert, wird das Layout vielfach einem Verfahren zur Verifikation unterworfen, ehe ausgehend von dem verifizierten Layout ein Maskensatz hergestellt wird. Bei der Verifikation wird untersucht, ob die Strukturen der integrierten Schaltung, die entsprechend dem Layout vorgesehen sind, tatsächlich die elektrischen Eigenschaften aufweisen, die im Schaltungsent-wurf spezifiziert sind.

Da die Schaltgeschwindigkeit integrierter Schaltungen empfindlich von den in der Schaltung auftretenden Verdrahtungskapazitäten abhängt, werden bei der Verifikation Kapazitätsberechnungen durchgeführt. Dazu werden Verdrahtungsnetze, vielfach auch Netze genannt, betrachtet. Als Verdrahtungsnetz wird ein leitender Pfad innerhalb der hochintegrierten Schaltung verstanden. Dieser kann verzweigt sein und kann sich über die gesamte Fläche der integrierten Schaltung erstrekken. Verschiedene Verdrahtungsnetze sind gegeneinander isoliert. Bei der Kapazitätsberechnung muß die Kapazität zwischen diesen Netzen bestimmt werden. Dieses kann für hochgenaue Berechnungen im Deep-Submicron-Bereich nur noch von Programmen, sogenannten Fieldsolvern, durchgeführt werden, in denen die dreidimensionale Laplace-Gleichung numerisch gelöst wird. Bei großen integrierten Schaltungen mit einer Chipfläche von einigen cm² kann diese Laplace-Gleichung jedoch aus Komplexitätsgründen mit heute verfügbaren Rechnern nicht als Ganzes behandelt werden. Daher ist es üblich, bei der Kapazitätsberechnung Partitionierungszellen zu definieren, für die die dreidimensionale Laplace-Gleichung numerisch lösbar ist.

Es ist vorgeschlagen worden (siehe zum Beispiel Z. Zhu et al, IEEE Transaction on Mircowave Theory and Techniques Vol. 45, No. 8, August 1997, pp. 1179 bis 1184, Z. Zhu et al, Vol. 46, No. 8, August 1998, pp. 1037 bis 1044, E. A. Dengi-et al, in proceeding of DAC 1997, pp. 1 bis 6 und A. H. Zemanian et al, IEEE Transaction on Computer-Aided Design Vol 8, No. 12, December 1989, pp. 1319 bis 1326), zur Behandlung dieses Problems eine sogenannte "Domain-Decomposition" durchzuführen, bei der die Partitionierungszellen durch elektrostatische Randbedingungen aller Verdrahtungsnetze bestimmt werden. Diese Vorgehensweise wurde in der Literatur bisher aber nur anhand von relativ kleinen hochintegrierten Schaltungen dargelegt, wobei die Chipfläche auf maximal 200 µm² begrenzt war, da die Bestimmung dieser elektrostatischen Randbedingungen aller Verdrahtungsnetze aufwendig ist.

Darüber hinaus ist vorgeschlagen worden (siehe zum Beispiel Y. L.-Le Coz et al, Solid State Electronics, Vol. 35, No. 7, pp. 1005 bis 1012, 1192), die Laplace-Gleichung stochastisch zu lösen. Dabei treten jedoch statistische Fehler auf. Ferner ist die Berechnung von Koppelanteilen zwischen verschiedenen Verdrahtungsnetzen bei gleicher Laufzeit nur ungenauer möglich. Schließlich ist dieses Verfahren auf Strukturen mit 45° und 90° Winkeln eingeschränkt.

In der Druckschrift US 5,452,224 A ist ein Verfahren beschrieben, bei dem die Verdrahtungskapazität eines wandernden rechteckigen Ausschnittsfensters auf dem Schaltungslayout berechnet wird.

Der Erfindung liegt das Problem zugrunde, ein Verfahren und eine Anordnung zur Verifikation eines Layouts einer integrierten Schaltung mit Hilfe eines Rechners anzugeben, das zur Herstellung einer hochintegrierten Schaltung geeignet ist und das auch bei integrierten Schaltungen mit Chipflächen von einigen cm² mit vertretbarem Rechenaufwand durchführbar ist.

Dieses Problem wird gelöst durch ein Verfahren gemäß Anspruch 1 sowie eine Anordnung gemäß Anspruch 8. Weitere Ausgestaltungen der Erfindung gehen aus den übrigen Ansprüchen hervor.

Zur Verifikation eines Layouts wird ein Verdrahtungsnetz ausgewählt, das in dem Layout enthalten ist. Das Verdrahtungsnetz ist eine leitende Struktur aus zusammenhängenden Elementen, wie dotierten Halbleitergebieten, dotierten polykristallinen Halbleiterschichten, Metallschichten und dergleichen, die in verschiedenen Ebenen angeordnet sein können und die einander berühren oder überlappen. Das Verdrahtungsnetz kann auch leitende Teile eines Bauelementes enthalten. Ein Verdrahtungsnetz stellt somit eine zusammenhängende leitende Verbindung in der integrierten Schaltung dar. Für das selektierte Verdrahtungsnetz wird die Kapazität bezüglich der anderen Verdrahtungsnetze, die in dem Layout enthalten sind, dadurch berechnet, dass ein Filterpolygon bestimmt wird, dessen Form der Form des selektierten Verdrahtungsnetzes entspricht, wobei die Abmessungen des Filterpolygons gegenüber den Abmessungen des selektierten Verdrahtungsnetzes um eine vorgebbare Weite vergrößert sind. Das Filterpolygon ist somit eine geometrische Fläche, die durch Vergrößerung der geometrischen Fläche des selektierten Verdrahtungsnetzes um die vorgebbare Weite entsteht.

Nachfolgend werden die Anteile aller Verdrahtungsnetze bestimmt, die mit dem Filterpolygon überlappen. Diese Anteile können im Bereich des Filterpolygons sowohl in der gleichen Ebene wie das selektierte Verdrahtungsnetz als auch in darüber oder darunter liegenden Ebenen angeordnet sein. Es wird die Kapazität zwischen dem selektierten Verdrahtungsnetz und den Anteilen der anderen Verdrahtungsnetze, die mit dem Filterpolygon überlappen, berechnet. Außerhalb des Filterpolygons angeordnete Anteile der anderen Verdrahtungsnetze werden bei der Kapazitätsberechnung nicht berücksichtigt. In diesem Verfahren wird die Tatsache ausgenutzt, daß der Beitrag zur Kapazität mit dem Abstand zwischen leitenden Strukturen abnimmt. Über die vorgebbare Weite wird in dem Verfahren gesteuert, welche Beiträge bei der Kapazitätsberechnung noch berücksichtigt werden sollen.

Da in dem Verfahren nur das selektierte Verdrahtungsnetz als Ganzes betrachtet wird und nur die Kapazitäten zwischen dem selektierten Verdrahtungsnetz und den im Bereich des Filterpolygons angeordneten Anteile der anderen Verdrahtungsnetze berechnet werden, sinkt der Rechenaufwand erheblich.

Zur Verifikation von Layouts sehr großer integrierter Schaltungen ist es vorteilhaft, das Filterpolygon in Partitionierungszellen zu zerlegen, deren Abmessungen eine Maximalabmessung nicht überschreiten. Dazu werden die Abmessungen des Filterpolygons mit der vorgegebenen Maximalabmessung verglichen und, falls das Filterpolygon in einer Abmessung die Maximalabmessung überschreitet, das Filterpolygon in kleinere Partitionierungszellen zerlegt. Es wird dann je Partitionierungszelle die Kapazität zwischen dem selektierten Verdrahtungsnetz und den Anteilen der anderen Verdrahtungsnetze, die mit der jeweiligen Partitionierungszelle überlappen, berechnet. Über die Größe der Partitionierungszelle wird die Komplexität der zu lösenden dreidimensionalen Laplace-Gleichung reduziert. Darüber hinaus können die verschiedenen Partitionierungszellen parallel abgearbeitet werden, so daß das Ergebnis in kürzerer Zeit ermittelt werden kann. Die Parallelisierung kann unter Einsatz mehrerer Prozessoren erfolgen.

Da die Gesamtheit der Partitionierungszellen das Filterpolygon ergibt, dessen Form aus einem Vergrößern des selektierten Verdrahtungsnetzes hervorgegangen ist, wird durch diese Partitionierung in den meisten Fällen nur innerhalb derjenigen Regionen eine Zerscheidung des selektierten Netzes durchgeführt, in denen homogene elektrostatische Randbedingungen vorliegen.

Die Zerlegung des Filterpolygons in die Partitionierungszellen kann auf unterschiedliche Weise erfolgen. Vorzugsweise erfolgt die Zerlegung des Filterpolygons durch Verwendung von senkrechten und waagerechten Schnittlinien in der Ebene des Filterpolygons, wobei die Schnittlinien jeweils Unstetigkeitspunkte in.der Kontur des Filterpolygons schneiden. Die auf diese Weise gewonnenen Teilpolygone werden bezüglich ihrer Abmessungen überprüft und, sofern eine ihrer Abmessungen die Maximalabmessung überschreitet, weiter unterteilt. Diese Vorgehensweise basiert auf dem sogenannten "Scanline-Algorithmus".

Die Größe der Maximalabmessung beeinflußt einerseits die benötigte Rechenzeit für die Kapazitätsberechnung, andererseits beeinflußt sie die erzielbare Genauigkeit bei der Kapazitätsberechnung. Im Hinblick auf die benötigte Rechenzeit ist eine geringe Maximalabmessung anzustreben, im Hinblick auf die Rechengenauigkeit dagegen eine Maximalabmessung, die einen Grenzwert nicht unterschreitet. Vorzugsweise beträgt die Maximalabmessung 25 µm bis 50 µm bei einer 0,35 µm-Technologie. Im Fall einer Technologie mit-minimaler Strukturgröße F beträgt die Maximalabmessung zwischen 70F und 140F.

Ergeben sich bei der Partitionierung einzelne Partitionierungszellen mit Abmessungen, die geringer als eine vorgegebene Minimalabmessung sind, so ist es im Hinblick auf den Rechenaufwand vorteilhaft, diese kleinen Partitionierungszellen mit einer benachbarten Partitionierungszelle zusammenzufassen. Dadurch steigt auch die Rechengenauigkeit, die bei sehr kleinen Abmessungen der Partitionierungszellen unbefriedigend ist. Vorzugsweise liegt die Minimalabmessung zwischen 15 µm und 25 µm bei einer 0,35 µm-Technologie. Im Fall einer Technologie mit minimaler Strukturgröße F liegt die Minimalabmessung vorzugsweise zwischen 40F und 70F.

Es liegt im Rahmen der Erfindung, daß die Koordinaten der Verdrahtungsnetze als Datenbasis in dem Rechner gespeichert sind. Zu jeder Partitionierungszelle wird eine Datei erzeugt, die Informationen über die Geometrie der jeweiligen Partitionierungszelle und über den Überlapp mit den anderen Verdrahtungsnetzen enthält.

Zur Herstellung einer integrierten Schaltung wird ausgehend von einem Schaltungsentwurf mit Hilfe eines Rechners ein Layout erstellt. Das Layout weist Verdrahtungsnetze auf. Zur Verifikation des Layouts wird anschließend mit Hilfe eines Rechners ein Verdrahtungsnetz selektiert, für das nach der oben beschriebenen Methode die Kapazität bezüglich der anderen Verdrahtungsnetze im Bereich eines Filterpolygons berechnet wird. Die berechnete Kapazität wird dann mit dem Schaltungsentwurf verglichen. Bei Performance-Einbußen wird das Layout, zum Beispiel durch Anpassung der Breiten der leitenden Strukturen, optimiert. Ausgehend von dem verifizierten Layout wird ein Maskensatz hergestellt, der zur Herstellung der integrierten Schaltung verwendet wird. Als verifiziertes Layout wird das Layout bezeichnet, das aufgrund des Verifikationsverfahrens die gewünschten elektrischen Eigenschaften aufweist oder das aufgrund von Abweichungen optimiert wurde.

Es liegt im Rahmen der Erfindung, mehrere Verdrahtungsnetze zu selektieren, für die jeweils ein Filterpolygon bestimmt wird und die Kapazität bezüglich der anderen Verdrahtungsnetze bestimmt wird. Die Beiträge der verschiedenen selektierten Verdrahtungsnetze können dabei parallel, insbesondere unter Verwendung mehrerer Prozessoren, berechnet werden.

Im folgenden wird die Erfindung anhand der Figuren, in denen Ausführungsbeispiele dargestellt sind, näher erläutert. Die Darstellungen in den Figuren sind nicht maßstäblich.
- Figur 1: zeigt ein lineares Verdrahtungsnetz mit zugehörigem Filterpolygon.
- Figur 2: zeigt ein komplexeres Verdrahtungsnetz mit zugehörigem Filterpolygon sowie den Anteilen anderer Verdrahtungsnetze, die mit dem Filterpolygon überlappen.
- Figur 3: zeigt ein Filterpolygon mit Schnittgeraden zur Partitionierung.
- Figur 4: zeigt zeigt ein Filterpolygon nach Festlegung erster Partitionierungszellen.
- Figur 5: zeigt das Filterpolygon nach Festlegung zweiter Partitionierungszellen.
- Figur 6: zeigt das Filterpolygon nach Festlegung dritter und vierter Partitionierungszellen.
- Figur 7: zeigt das Filterpolygon nach Festlegung fünfter Partitionierungszellen.
- Figur 8: zeigt ein Ablaufdiagramm zur Herstellung einer integrierten Schaltung.
- Figur 9: zeigt die Kapazität eines linearen Verdrahtungsnetzes als Funktion der Länge 1 einer Partitionierungszelle.

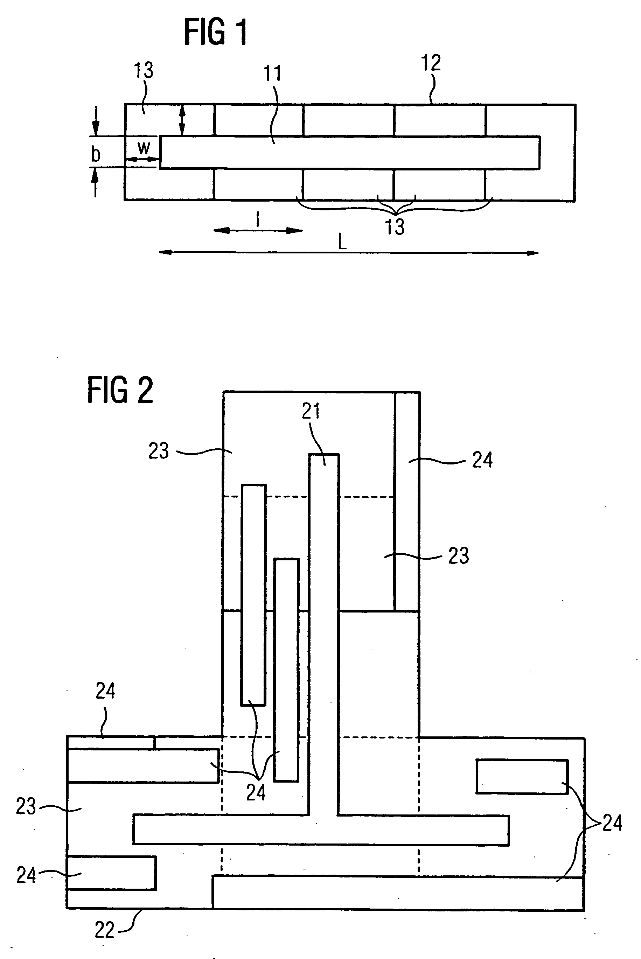

Ein lineares Verdrahtungsnetz 11 weist eine Breite b von 0,6 µm und eine Länge L von 130 µm auf. Dem Verdrahtungsnetz 11 wird ein Filterpolygon 12 zugeordnet, das aus dem Verdrahtungsnetz 11 dadurch gewonnen wird, daß die Kontur des Verdrahtungsnetzes 11 beidseitig um jeweils w = 5 µm vergrößert wird. Das Filterpolygon 12 weist somit eine Breite von b + 2w und eine Länge von L + 2w auf. Das Filterpolygon 12 wird in Partitionierungszellen 13 zerlegt, die parallel zur Länge L des Verdrahtungsnetzes 11 eine Länge von 1 = 25 µm aufweisen. Dazu wird das Filterpolygon 12 ausgehend von einer Seite her in Rechtecke der Länge 1 zerlegt (siehe Figur 1). Dabei kann die letzte Partitionierungszelle eine von der Länge 1 unterschiedliche Länge aufweisen, falls die Länge des Filterpolygons 12 kein ganzzahliges Vielfach von der Länge 1 ist.

Ein selektiertes Verdrahtungsnetz 21 weist einen im wesentlichen T-förmigen Querschnitt auf (siehe Figur 2). Dem selektierten Verdrahtungsnetz 21 ist ein Filterpolygon 22 zugeordnet, das ebenfalls einen T-förmigen Querschnitt aufweist, das jedoch gegenüber den Abmessungen des selektierten Verdrahtungsnetzes 21 beidseitig jeweils um eine Weite w = 5 µm vergrößert ist. Das Filterpolygon 22 ist in Partitionierungszellen 23 zerlegt, deren Abmessungen kleiner als eine Maximalabmessung von 25 µm ist. Das Filterpolygon 22 überlappt Anteile 24 anderer Verdrahtungsnetze. Das selektierte Verdrahtungsnetz 21 und die Anteile 24 anderer Verdrahtungsnetze sind in ein und demselben Layout enthalten.

Zur Verifikation des Layouts, das das selektierte Verdrahtungsnetz 21 und die Anteile 24 anderer Verdrahtungsnetze enthält, wird die Kapazität zwischen dem selektierten Verdrahtungsnetz und den Anteilen 24 der anderen Verdrahtungsnetze jeweils pro Partitionierungszelle 23 berechnet.

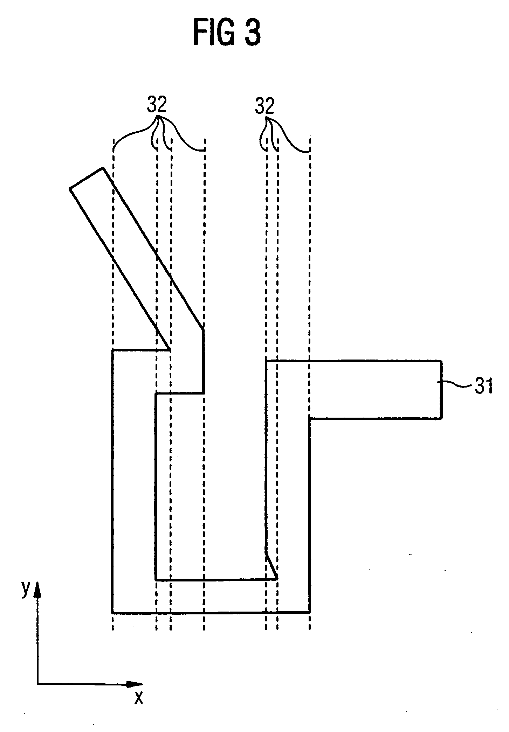

Die Partitionierung eines Filterpolygons erfolgt vorzugsweise nach einem sogenannten Scanline-Algorithmus, bei dem ein Filterpolygon 31 mit Schnittgeraden 32, die parallel zu einer y-Achse y verlaufen, überlagert wird. Die Schnittgeraden 32 werden so gelegt, daß sie jeweils durch Unstetigkeiten in der Kontur des Filterpolygons 31 laufen (siehe Figur 3). Es werden dabei Rechtecke bestimmt, die durch zwei benachbarte Schnittgeraden 32 und zu einer x-Achse x parallele Teile der Kontur des Filterpolygons 31 begrenzt werden. Ein ähnlicher Algorithmus ist im Zusammenhang mit einer Widerstandszerlegung von Netzen in M. Horowitz et al, IEEE Transaction on Computer Aided Design, Vol CAD-2, No. 3, July 1993, pp. 145, beschrieben worden. Dort wird mit Hilfe dieses Algorithmus die Form einer Leiterbahn, deren Widerstand berechnet werden soll, in Partitionierungszellen zerlegt.

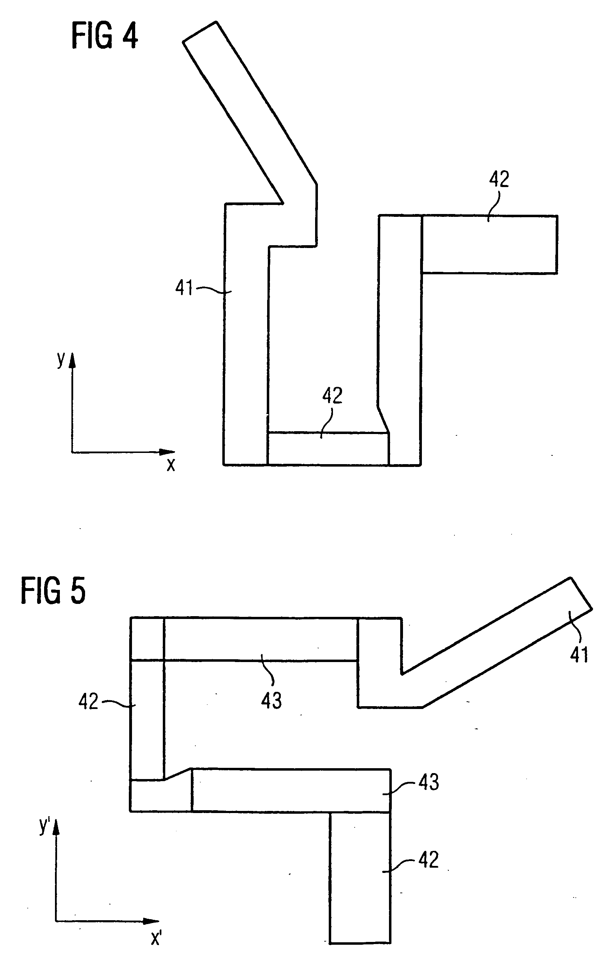

Anhand der Figuren 4 bis 7 wird im folgenden die schrittweise Partitionierung eines Filterpolygons 41 erläutert.

In dem Filterpolygon 41 werden durch Überlagerung mit zu einer y-Achse y parallelen Schnittgeraden erste Partitionierungszellen definiert. Die ersten Partitionierungszellen 42 weisen parallel zu einer x-Achse x eine größere Ausdehnung als parallel zu einer y-Achse y auf. Die ersten Partitionierungszellen 42 sind parallel zur x-Achse x durch Teile der Kontur des Filterpolygons 41 begrenzt.

Im nächsten Schritt werden die ersten Partitionierungszellen 42 in einer Datei gespeichert und die Restpolygone des Filterpolygons 41 miteinander verschmolzen. Darunter versteht man ein Herausfiltern der ersten Partitionierungszellen 42.

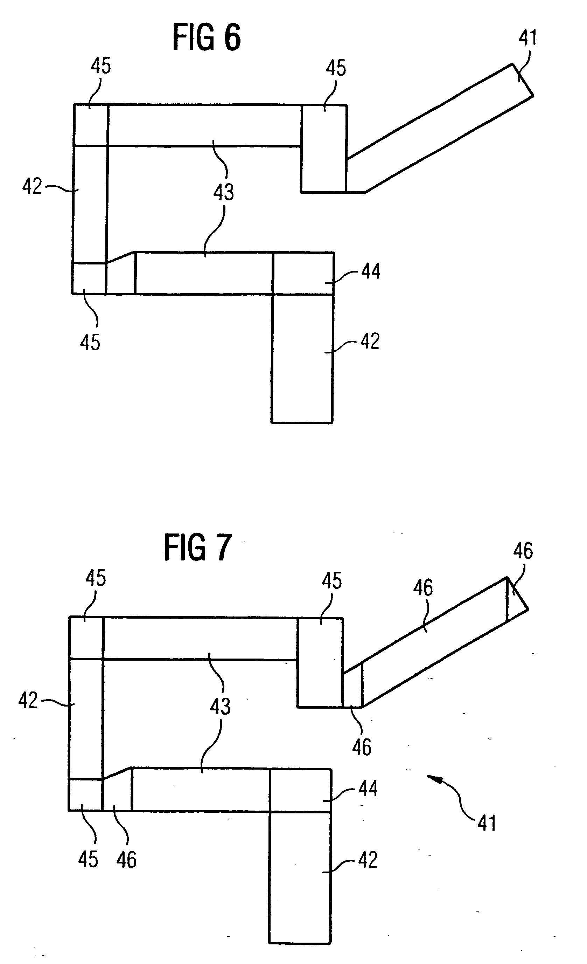

Anschließend wird das Filterpolygon 41 im Uhrzeigersinn um 90° rotiert. Durch Überlagerung mit Schnittgeraden, die parallel zur y-Achse y verlaufen, werden zweite Partitionierungszellen 43 erzeugt, die parallel zu einer rotierten x-Achse x' größer als parallel zu einer rotierten y-Achse y' sind. Da die rotierte x-Achse x' um 90° gegenüber der x-Achse x aus Figur 4 verdreht ist, sind die ersten Partitionierungszellen 42 senkrecht zu den zweiten Partitionierungszellen 43 angeordnet (siehe Figur 5).

Die zweiten Partitionierungszellen 43 werden herausgefiltert und gespeichert.

Nachfolgend werden die ersten Partitionierungszellen 42 durch die zweiten Partitionierungszellen 43 weiter unterteilt, sofern sich die ersten Partitionierungszellen 42 und die zweiten Partitionierungszellen 43 berühren. Dabei entstehen dritte Partitionierungszellen 44, die sowohl an die benachbarte erste Partitionierungszelle 42 als auch an die benachbarte zweite Partitionierungszelle 43 angrenzen (siehe Figur 6).

Für die Restpolygone wird untersucht, ob sich diese in weitere Rechtecke zerlegen lassen. Diese Rechtecke werden als vierte Partitionierungszellen 45 gespeichert und herausgefiltert (siehe Figur 6).

Die restlichen Polygone werden durch Überlagerung mit Schnittgeraden an Unstetigkeiten ihrer Konturen weiter unterteilt. Dabei entstehen fünfte Partitionierungszellen 46, die gespeichert werden (siehe Figur 7).

Nachfolgend wird überprüft, ob es Partitionierungszellen gibt, deren Abmessung eine Maximalabmessung 1 = 25 µm überschreitet. Partitionierungszellen, die diese Maximalabmessung überschreiten, werden in n = L/l Rechtecke oder Trapeze unterteilt, wobei L die Länge der ursprünglichen Partitionierungszelle ist. Damit verbleiben nur Rechtecke oder Trapeze, deren Länge kleiner gleich 1 ist.

Partitionierungszellen, deren Länge kleiner als eine Minimalabmessung von zum Beispiel 15 µm ist, werden mit benachbarten Partitionierungszellen verschmolzen. Sollte die Abmessung der sich ergebenden Partitionierungszelle größer als die Maximalabmessung sein, so wird diese Partitionierungszelle in zwei im wesentlichen gleichgroße Partitionierungszellen unterteilt.

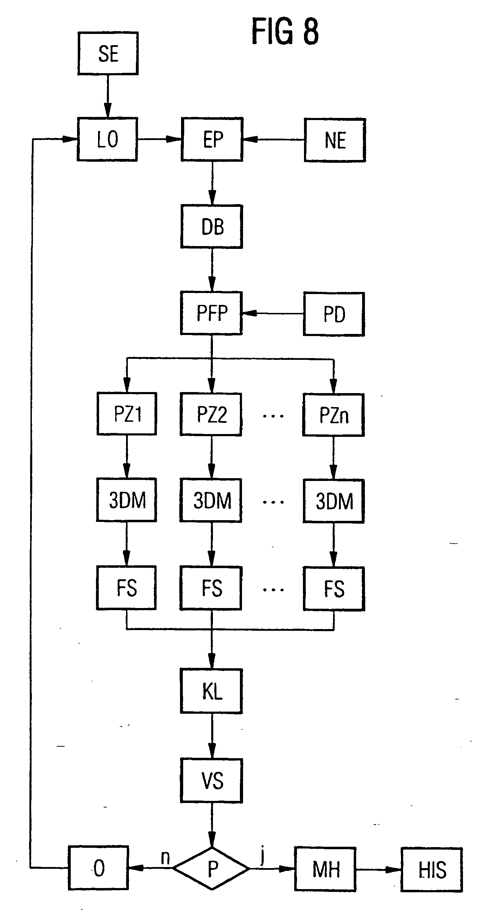

Zur Herstellung einer integrierten Schaltung wird ausgehend von einem Schaltungsentwurf SE mit Hilfe eines Rechners ein Layout LO erstellt (siehe Figur 8). Mit Hilfe eines Extraktionsprogrammes EP, dem Regeln zur Netzextraktion NE zur Verfügung stehen, werden aus dem Layout L die Koordinaten von Verdrahtungsnetzen extrahiert und in einer Datenbasis DB gespeichert. Mit einem Programm zur Erstellung eines Filterpolygons und zur Partitionierung PFP wird für ein selektiertes Verdrahtungsnetz ein Filterpolygon bestimmt. Mit dem Programm zur Definition des Filterpolygons und zur Partitionierung PFP wird ferner eine Zerlegung des Filterpolygons in Partitionierungszellen durchgeführt. Die Information zur Selektion des Verdrahtungsnetzes, zur Definition des Filterpolygons und zur Partitionierung werden aus einer Parameterdatei PD entnommen. Die Parameterdatei PD enthält insbesondere eine vorgebbare Weite w, um die das Filterpolygon gegenüber der Kontur des selektierten Verdrahtungsnetzes vergrößert wird, sowie eine Maximalabmessung 1 und eine Minimalabmessung für die Partitionierungszellen.

Der weitere Programmablauf erfolgt parallel für die Partitionierungszellen PZi, i = 1, 2 ... n. Für jede Partitionierungszelle PZi wird bestimmt, welche Anteile anderer Verdrahtungsnetze mit der Partitionierungszelle PZi überlappen. Dieser Schritt, der als 3D-Modellierung 3DM bezeichnet wird, erfolgt auf der Grundlage der Datenbasis DB. Nachfolgend wird für jede Partitionierungszelle PZi die Kapazität des selektierten Verdrahtungsnetzes bezüglich der Anteile anderer Verdrahtungsnetze, die die Partitionierungszelle PZi überlappen, berechnet. Diese Berechnung erfolgt mit einem Programm, das als Fieldsolver FS bezeichnet wird.

Die Ergebnisse der Kapazitätsberechnung für die Partitionierungszellen PZi, i = 1, 2 ... n, werden als Kapazitätsliste KL ausgegeben. Die Kapazitätsliste KL kann in einem Format ausgegeben werden, das von einem analogen Schaltkreissimulator verarbeitet werden kann. Ein solches Format ist unter dem Namen SPICE Netzliste gebräuchlich.

Nachfolgend werden die berechneten Kapazitäten der Kapazitätsliste KL in einem Vergleichsschritt VS mit den Kapazitäten des Schaltungsentwurfs SE verglichen. Dieser Vergleich erfolgt zum Beispiel anhand von dem im Schaltungsentwurf SE geforderten Zeitverhalten von Signalen. Es wird in einem Prüfungsschritt P überprüft, ob Übereinstimmung zwischen der berechneten Kapazität der Kapazitätsliste KL und der Kapazität des Schaltungsentwurfs SE vorliegt. Stimmen die Kapazitäten nicht überein, so wird in einem Optimierungsschritt O das Layout LO modifiziert. Ausgehend von dem modifizierten Layout LO wird nachfolgend das Verfahren zur Verifikation erneut durchgeführt. Stimmen die Kapazitätswerte überein, so wird ausgehend von dem verifizierten Layout die Maskenherstellung MH durchgeführt. Dabei werden alle erforderlichen Maskensätze für die technologische Realisierung der integrierten Schaltung erzeugt. Unter Verwendung der auf diese Weise hergestellten Masken erfolgt die Herstellung HIS der integrierten Schaltung.

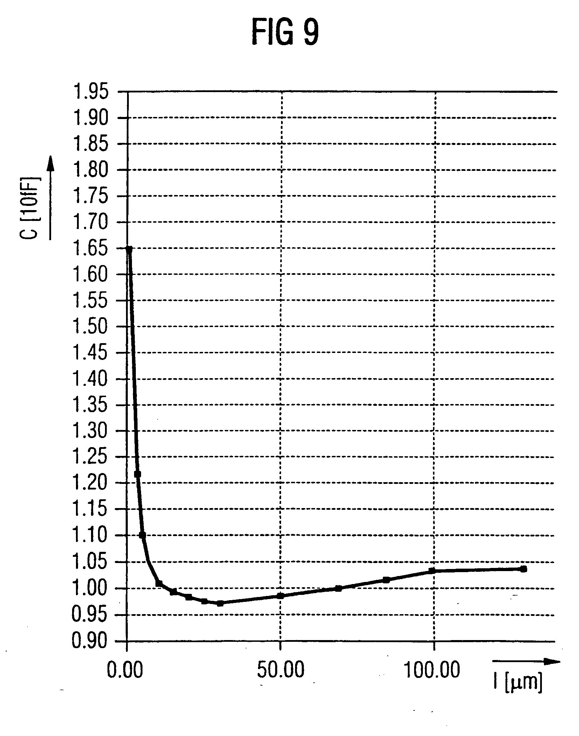

Figur 9 ist die Abhängigkeit der berechneten Kapazität C von der Länge 1 der Partitionierungszelle zu entnehmen. Ohne Partitionierung, das heißt für unendlich großes 1, ergibt sich eine Kapazität von 10,3 fF. Figur 9 ist zu entnehmen, daß für eine Länge der Partitionierungszelle größer 25 µm die Ungenauigkeit der Kapazität maximal 5 Prozent beträgt. Die Weite w, um die das Filterpolygon gegenüber dem selektierten Verdrahtungsnetz beiderseits vergrößert ist, beträgt 5 µm.

## Patentansprüche

1. Verfahren zur Verifikation eines Layouts einer integrierten Schaltung mit Hilfe eines Rechners,
- bei dem für ein selektiertes Verdrahtungsnetz (11, 21), das in dem Layout enthalten ist, die Kapazität bezüglich anderer Verdrahtungsnetze, die in dem Layout enthalten sind, **dadurch** berechnet wird,
- dass ein Filterpolygon (12, 22, 31, 41) bestimmt wird, das die Form des selektierten Verdrahtungsnetzes (11, 21) umgibt, wobei die Abmessungen des Filterpolygons (12, 22, 31, 41) gegenüber den Abmessungen des selektierten Verdrahtungsnetzes (11, 21) um eine vorgegebene Weite (w) vergrößert sind,
- dass die Anteile (24) der anderen Verdrahtungsnetze bestimmt werden, die mit dem Filterpolygon (12, 22, 31, 41) überlappen,
- dass die Kapazität zwischen dem selektierten Verdrahtungsnetz (11, 21) und den Anteilen (24) der anderen Verdrahtungsnetze, die mit dem Filterpolygon (12, 22, 31, 41) überlappen, bestimmt wird.

2. Verfahren nach Anspruch 1,
- bei dem die Abmessungen des Filterpolygons (12, 22, 31, 41) mit einer vorgegebenen Maximalabmessung verglichen werden,
- bei dem, falls eine Abmessung des Filterpolygons (12, 22, 31, 41) größer als die vorgegebene Maximalabmessung ist, das Filterpolygon (12, 22, 31, 41) in Partitionierungszellen (13, 42 - 46) zerlegt wird, deren Abmessungen die Maximalabmessung nicht überschreiten,
- bei dem je Partitionierungszelle (13, 42 - 46) die Kapazität zwischen dem selektierten Verdrahtungsnetz (11, 21) und den Anteilen (24) der anderen Verdrahtungsnetze, die mit der jeweiligen Partitionierungszelle (13, 42 - 46) überlappen, berechnet wird.

3. Verfahren nach Anspruch 2,
bei einem die Zerlegung des Filterpolygons (12, 22, 31, 41) unter Verwendung von senkrechten und waagerechten Schnittlinien (32) erfolgt, die jeweils Unstetigkeitspunkte in der Kontur des Filterpolygons (12, 22; 31, 41) schneiden.

4. Verfahren nach Anspruch 3,
bei dem eine der Partitionierungszellen (13, 42 - 46) mit Abmessungen, die geringer als eine vorgegebene Minialabmessung sind, mit einer benachbarten Partitionierungszelle (13, 42 - 46) zusammengefaßt wird.

5. Verfahren nach einem der Ansprüche 2 bis 4,
- bei dem die Koordinaten der Verdrahtungsnetze (11, 21) als Netzliste in dem Rechner gespeichert sind,
- bei dem zu jeder Partitionierungszelle (13, 42 - 46) eine Datei erzeugt wird, die Informationen über die Geometrie der jeweiligen Partitionierungszelle (13, 42 - 46) und über den Überlapp mit den anderen Verdrahtungsnetzen enthält.

6. Verfahren nach einem der Ansprüche 1 bis 5,
- bei dem für mehrere selektierte Verdrahtungsnetze (11, 21), die in dem Layout enthalten sind, die Kapazität bezüglich aller anderen Verdrahtungsnetze, die in dem Layout enthalten sind, **dadurch** berechnet wird,
- dass jeweils ein Filterpolygon (12, 22, 31, 41) bestimmt wird, das die Form des jeweiligen selektierten Verdrahtungsnetzes (11, 21) umgibt, wobei die Abmessungen des Filterpolygons (12, 22, 31, 41) gegenüber den Abmessungen des selektierten Verdrahtungsnetzes (11, 21) um eine vorgebene Weite (w) vergrößert sind,
- dass jeweils die Anteile (24) aller anderen Verdrahtungsnetze bestimmt werden, die mit dem jeweiligen Filterpolygon (12, 22, 31, 41) überlappen,
- dass jeweils die Kapazität zwischen dem selektierten Verdrahtungsnetz (11, 21) und den Anteilen (24) aller anderen Verdrahtungsnetze, die mit dem jeweiligen Filterpolygon (12, 22, 31, 41) überlappen, bestimmt wird.

7. Verfahren nach einem der Ansprüche 1 bis 6,
- bei dem das Verdrahtungsnetze (11, 21) aufweisende Layout ausgehend von einem Schaltungsentwurf mit Hilfe eines Rechners erstellt wird,
- bei dem die bestimmte Kapazität mit dem Schaltungsentwurf verglichen und bei einer Abweichung das Layout optimiert wird, und
- bei dem ausgehend von dem verifizierten Layout ein Maskensatz hergestellt wird, der zur Herstellung einer integrierten Schaltung verwendet wird.

8. Anordnung zur Verifikation eines Layouts einer integrierten Schaltung mit Hilfe eines Rechners,
- bei der eine Prozessoreinheit vorgesehen ist, die so angepaßt ist, daß für ein selektiertes Verdrahtungsnetz (11, 21), das in einem Layout enthalten ist, die Kapazität bezüglich anderer Verdrahtungsnetze, die in dem Layout enthalten sind, berechnet wird, indem die Prozessoreinheit umfaßt:
- Mittel, um ein Filterpolygon (12, 22, 31, 41) zu bestimmen das die Form des selektierten Verdrahtungsnetzes (11, 21) umgibt, wobei die Abmessungen des Filterpolygons (12, 22, 31, 41) gegenüber den Abmessungen des selektierten Verdrahtungsnetzes (11, 21) um eine vorgegebene Weite (w) vergrößert sind,
- Mittel, um die Anteile (24) der anderen Verdrahtungsnetze zu bestimmen, die mit dem Filterpolygon (12, 22, 31, 41) überlappen,
- Mittel, um die Kapazität zwischen dem selektierten Verdrahtungsnetz (11, 21) und den Anteilen (24) der anderen Verdrahtungsnetze, die mit dem Filterpolygon (12, 22, 31, 41) überlappen, zu bestimmen.

9. Anordnung nach Anspruch 8,
- bei der mehrere Prozessoreinheiten vorgesehen und derart angepasst sind, dass jeweils für eines von mehreren selektierten Verdrahtungsnetzen (11, 21), die in dem Layout enthalten sind, die Kapazität bezüglich aller anderen Verdrahtungsnetze, die in dem Layout enthalten sind, **dadurch** berechenbar ist,
- dass jeweils ein Filterpolygon (12, 22, 31, 41) bestimmt wird, das die Form des jeweiligen selektierten Verdrahtungsnetzes (11, 21) umgibt, wobei die Abmessungen des Filterpolygons (12, 22, 31, 41) gegenüber den Abmessungen des selektierten Verdrahtungsnetzes (11, 21) um eine vorgegebene Weite (w) vergrößert sind,
- dass die Anteile (24) der anderen Verdrahtungsnetze bestimmt werden, die mit dem jeweiligen Filterpolygon (12, 22, 31, 41) überlappen,
- dass die Kapazität zwischen dem jeweiligen selektierten Verdrahtungsnetz (11, 21) und den Anteilen (24) der anderen Verdrahtungsnetze, die mit dem jeweiligen Filterpolygon (12, 22, 31, 41) überlappen, bestimmt wird.

## Claims

1. Method for verification of a layout of an integrated circuit with the aid of a computer,
- in which, for a selected interconnection network (11, 21) contained in the layout, the capacitance with respect to other interconnection networks contained in the layout is calculated as follows:
- a filter polygon (12, 22, 31, 41) is determined which surrounds the form of the selected interconnection network (11, 21), the dimensions of the filter polygon (12, 22, 31, 41) being enlarged by a predetermined extent (w) relative to the dimensions of the selected interconnection network (11, 21),
- the portions (24) of the other interconnection networks which overlap the filter polygon (12, 22, 31, 41) are determined,
- the capacitance between the selected interconnection network (11, 21) and the portions (24) of the other interconnection networks which overlap the filter polygon (12, 22, 31, 41) is determined.

2. Method according to Claim 1,
- in which the dimensions of the filter polygon (12, 22, 31, 41) are compared with a predetermined maximum dimension,
- in which, if a dimension of the filter polygon (12, 22, 31, 41) is larger than the predetermined maximum dimension, the filter polygon (12, 22, 31, 41) is split into partitioning cells (13, 42-46) whose dimensions do not exceed the maximum dimension,
- in which, for each partitioning cell (13, 42-46), the capacitance between the selected interconnection network (11, 21) and the portions (24) of the other interconnection networks which overlap the respective partitioning cell (13, 42-46) is calculated.

3. Method according to Claim 2,
in which the filter polygon (12, 22, 31, 41) is split using vertical and horizontal lines of intersection (32) which in each case intersect discontinuity points in the contour of the filter polygon (12, 22, 31, 41).

4. Method according to Claim 3,
in which one of the partitioning cells (13, 42-46) having dimensions which are smaller than a predetermined minimum dimension is combined with an adjacent partitioning cell (13, 42-46).

5. Method according to one of Claims 2 to 4,
- in which the coordinates of the interconnection network (11, 21) are stored as a network list in the computer,
- in which, for each partitioning cell (13, 42-46), a file is generated which contains information about the geometry of the respective partitioning cell (13, 42-46) and about the overlap with the other interconnection networks.

6. Method according to one of Claims 1 to 5,
- in which, for a plurality of selected interconnection networks (11, 21) contained in the layout, the capacitance with respect to all the other interconnection networks contained in the layout is calculated as follows:
- in each case a filter polygon (12, 22, 31, 41) is determined which surrounds the form of the respective selected interconnection network (11, 21), the dimensions of the filter polygon (12, 22, 31, 41) being enlarged by a predetermined extent (w) relative to the dimensions of the selected interconnection network (11, 21),
- in each case the portions (24) of all the other interconnection networks which overlap the respective filter polygon (12, 22, 31, 41) are determined,
- in each case the capacitance between the selected interconnection network (11, 21) and the portions (24) of all the other interconnection networks which overlap the respective filter polygon (12, 22, 31, 41) is determined.

7. Method according to one of Claims 1 to 6,
- in which, proceeding from a circuit design, the layout having interconnection networks (11, 21) is created with the aid of a computer,
- in which the determined capacitance is compared with the circuit design and the layout is optimized in the event of a deviation, and
- in which, proceeding from the verified layout, a mask set is fabricated which is used to fabricate the integrated circuit.

8. Arrangement for verification of a layout of an integrated circuit with the aid of a computer,
- in which a processor unit is provided, which is adapted such that, for a selected interconnection network (11, 21) contained in a layout, the capacitance with respect to other interconnection networks contained in the layout is calculated in that the processor unit comprises:
- means for determining a filter polygon (12, 22, 31, 41) which surrounds the form of the selected interconnection network (11, 21), the dimensions of the filter polygon (12, 22, 31, 41) being enlarged by a predetermined extent (w) relative to the dimensions of the selected interconnection network (11, 21),
- means for determining the portions (24) of the other interconnection networks which overlap the filter polygon (12, 22, 31, 41),
- means for determining the capacitance between the selected interconnection network (11, 21) and the portions (24) of the other interconnection networks which overlap the filter polygon (12, 22, 31, 41).

9. Arrangement according to Claim 8,
- in which a plurality of processor units are provided and are adapted in such a way that in each case for one of a plurality of selected interconnection networks (11, 21) contained in the layout, the capacitance with respect to all the other interconnection networks contained in the layout can be calculated as follows:
- in each case a filter polygon (12, 22, 31, 41) is determined which surrounds the form of the respective selected interconnection network (11, 21), the dimensions of the filter polygon (12, 22, 31, 41) being enlarged by a predetermined extent (w) relative to the dimensions of the selected interconnection network (11, 21),
- the portions (24) of the other interconnection networks which overlap the respective filter polygon (12, 22, 31, 41) are determined
- the capacitance between the respective selected interconnection network (11, 21) and the portions (24) of the other interconnection networks which overlap the respective filter polygon (12, 22, 31, 41) is determined.

## Revendications

1. Procédé de vérification d'une topologie d'un circuit intégré à l'aide d'un ordinateur, dans lequel
- on calcule pour un réseau de câblage sélectionné (11, 21), qui est contenu dans la topologie, la capacité par rapport à d'autres réseaux de câblage qui sont contenus dans la topologie,
- en déterminant à un polygone de filtrage (12, 22, 31, 41) qui entoure la forme du réseau de câblage sélectionné (11, 21), les dimensions du polygone de filtrage (12, 22, 31, 41) étant augmentées d'une grandeur prescrite (w) par rapport aux dimensions du réseau de câblage sélectionné (11, 21),
- en déterminant les portions (24) des autres réseaux de câblage qui sont recouvertes par le polygone de filtrage (12, 22, 31, 41),
- en déterminant la capacité entre le réseau de câblage sélectionné (11, 21) et les portions (24) des autres réseaux de câblage qui sont recouvertes par le polygone de filtrage (12, 22, 31, 41).

2. Procédés selon la revendication 1, dans lequel
- les dimensions du polygone de filtrage (12, 22, 31, 41) sont comparées à une dimension maximale prescrite,
- dans le cas où une dimension du polygone de filtrage (12, 22, 31, 41) est supérieure à la dimension maximale prescrite, le polygone de filtrage (12, 22, 31, 41) est subdivisé en cellules de partitionnement (13, 42 à 46) dont les dimensions ne sont pas supérieures à la dimension maximale,
- on calcule pour chaque cellule de partitionnement (13, 42 à 46,) la capacité entre le réseau de câblage sélectionné (11, 21) et les portions (24) des autres réseaux de câblage qui sont recouvertes par la cellule de partitionnement respective (13, 42 à 46).

3. Procédé selon la revendication 2, dans lequel la subdivision du polygone de filtrage (12, 22, 31, 41) est effectuée en utilisant des lignes de coupe horizontales et verticales (32) qui passent chacune par des points de discontinuité dans le contour du polygone de filtrage (12, 22, 31, 41).

4. Procédé selon la revendication 3, dans lequel l'une des cellules de partitionnement (13, 42 à 46) ayant des dimensions qui sont inférieures à une dimension minimale prescrite, est regroupée à une cellule de partitionnement voisine (13, 42 à 46).

5. Procédé selon l'une des revendications 2 à 4, dans lequel
- les coordonnées des réseaux de câblage (11, 21) sont mémorisées sous la forme de listes de réseaux dans le ordinateur,
- on génère pour chaque cellule de partitionnement (13, 42 à 46) un fichier qui contient des informations sur la géométrie de la cellule de partitionnement respective (13, 42 à 46) et sur le recouvrement avec les autres réseaux de câblage.

6. Procédé selon l'une des revendications 1 à 5, dans lequel
- on calcule pour plusieurs réseaux de câblage sélectionnés (11, 21) qui sont contenus dans la topologie, la capacité par rapport à tous les autres réseaux de câblage qui sont contenus dans la topologie,
- en déterminant à chaque fois un polygone de filtrage (12, 22, 31, 41) qui entoure la forme du réseau de câblage sélectionné respectif (11, 21), les dimensions du polygone de filtrage (12, 22, 31, 41) étant augmentée d'une grandeur prescrite (w) par rapport aux dimensions du réseau de câblage sélectionné (11, 21),
- on détermine respectivement les portions (24) de tous les autres réseaux de câblage, qui sont recouverts par le polygone de filtrage respectif (12, 22, 31, 41),
- on détermine respectivement la capacité entre le réseau de câblage sélectionné (11, 21) et les portions (24) de tous les autres réseaux de câblage qui sont recouverts par le polygone de filtrage respectif (12, 22, 31, 41).

7. Procédé selon l'une des revendications 1 à 6, dans lequel
- la topologie comportant des réseaux de câblage (11, 21) est établie à partir d'un projet de circuit à l'aide d'un ordinateur,
- la capacité déterminée est comparée au projet de circuit et, en présence d'un écart, la topologie est optimisée, et
- on réalise à partir de la topologie vérifiée un ensemble de masques qui est utilisé pour fabriquer un circuit intégré.

8. Dispositif de vérification d'une topologie de circuit intégré à l'aide d'un ordinateur, dans lequel
- il est prévu une unité de processeurs qui est adapté pour calculer, pour un réseau de câblage sélectionné (11, 21) qui est contenu dans une topologie, la capacité par rapport à d'autres réseaux de câblage qui sont contenus dans la topologie, ce pour quoi l'unité de processeurs comporte :
- des moyens de détermination d'un polygone de filtrage (12, 22, 31, 41) qui entoure la forme du réseau de câblage sélectionné (11, 21), les dimensions du polygone de filtrage (12, 22, 31, 41) étant augmentées d'une grandeur prescrite (w) par rapport aux dimensions du réseau de câblage sélectionné (11, 21),
- des moyens de détermination des portions (24) des autres réseaux de câblage qui sont recouverts par le polygone de filtrage (12, 22, 31, 41),
- des moyens de détermination de la capacité entre le réseau de câblage sélectionné (11, 21) et les portions (24) des autres réseaux de câblage qui sont recouverts par le polygone de filtrage (12, 22, 31, 41).

9. Dispositif selon la revendication 8, dans lequel
- il est prévu plusieurs unités de processeurs qui sont adaptés pour calculer respectivement, pour l'un des plusieurs réseaux de câblage sélectionné (11, 21) qui sont contenus dans la topologie, la capacité par rapport à tous les autres réseaux de câblage qui sont contenus dans la topologie,
- en déterminant respectivement un polygone de filtrage (12, 22, 31, 41) qui entoure la forme du réseau de câblage sélectionné respectif (11, 21), les dimensions du réseau de filtrage (12, 22, 31, 41) étant augmentées d'une grandeur prescrite (w) par rapport aux dimensions du réseau de câblage sélectionné (11, 21),
- en déterminant les portions (24) des autres réseaux de câblage qui sont recouverts par le polygone de filtrage respectif (12, 22, 31, 41),
- en déterminant la capacité entre le réseau de câblage sélectionné respectif (11, 21) et les portions (24) des autres réseaux de câblage qui sont recouverts par le polygone de filtrage respectif (12, 22, 31, 41).
